# EUROPEAN PATENT SPECIFICATION

(11) **EP 1 990 698 B1**
(45) Date of publication and mention of the grant of the patent: **06.07.2011**
(21) Application number: 07107936.2
(22) Date of filing: 10.05.2007
(51) Int. Cl.: G05B 19/409, G05B 19/042, G05B 19/05, G06F 3/00, B23Q 1/00, F25D 29/00, D06F 39/00, A47L 15/42, F24C 7/08, H05K 5/00

(54) **Improved modular control panel for a household appliance**
Verbessertes modulares Bedienfeld für ein Haushaltsgerät
Panneau de contrôle modulaire amélioré pour un appareil électroménager

(43) Date of publication of application: 12.11.2008
(73) Proprietor: Electrolux Home Products Corporation N.V., 1130 Brussel (BE)
(72) Inventor: Capacci, Mirko, 47100 Forli' (IT); Tridello, Cris, 47100 Forli' (IT)
(74) Representative: Hochmuth, Jürgen

(56) References cited:
- EP-A- 1 128 510
- EP-A- 1 158 248
- EP-A1- 0 943 283
- EP-A2- 0 388 728
- DE-A1- 19 506 641

## Description

The present invention refers to a control panel according to the preamble of claim 1.

Control panels of the above-cited kind are generally known to be mass-produced in very large quantities on an industrial scale and therefore - considering also the quite extreme competitiveness requirements, which such products are generally required to comply with - they must ensure corresponding properties and capabilities of great flexibility In both their construction and their practical use, i.e. installation and assembly, in the various particular appliance types and models, in which they are due to operate.

Currently, however, such control panels are manufactured using throughout traditional techniques and materials, which involve production costs to be sustained that are not liable to be curbed or reduced to any significant extent any further, if the same manufacturing techniques and construction materials are kept being used in a substantially unaltered manner.

However, the situation is very frequently, if not habitually incurred in the related industry, in which a same screen display, i.e. a visual graphic display having the same operating characteristics and specifications, but a differing mechanical interface, has to be installed in different appliances having peculiar, i.e. specific control panels or requirements for the mechanical mounting; for this reason each programmer, or timer, must therefore be provided with specific support means for coupling to a respective specific type or kind of appliance.

In practice, this means that a given kind of electric programmer featuring general operating characteristics and specifications that would enable it to be used in a number of visually different appliances, cannot practically be manufactured in a standardized manner for all such appliances, but must rather be designed and manufactured so as to ensure that the graphic visual characteristics thereof are specific to each single type of appliance, which they are Intended for.

From a practical point of view, this production-related situation, although quite reliable and free of technical problems whatsoever, has however following three major drawbacks:

### a) High Production Costs

In fact, fragmenting control panel production into a plurality of types, which solely differ from each other for the visual graphic interface characteristics thereof, gives rise to significant diseconomies of scale in terms of both production and logistics, which anyone skilled in the art is able to readily appreciate, this being also the reason why this cost factor shall not be dealt with any further in this description.

### b) High Costs of Production Tools

Since the graphic Interfaces of each control panel must be designed and made In a manner that is specific to each and any type of appliance, which the control panels are Intended for, it ensues that also the related production tools and structures, i.e. the tools, dies and moulds used to produce the various programmers, must be selected so as to be specific to each and any type of appliance being produced. The high cost entrained by this further hindrance to production standardization Is therefore fully apparent.

### c) No-Interchangeability

The fact should at this point be once again stressed that in many industrial sectors, and in particular in the so-called white-goods or appliance industry, use is largely made of control panel types that would be functionally interchangeable, actually, even in appliances of different type and make, but cannot on the contrary be interchanged due to the specific design and character of the graphic interface and means thereof. This most obviously entrains a further difficulty for after-sales service organizations to keep - in their spare-parts warehouses - any adequate variety and quantity of control panels programmers types available for each and all of the various uses and applications thereof, notwithstanding the afore-noted fact that such programmers might well be considered to be fully interchangeable from a functional point of view, i.e. as far as their operating specifications are concerned.

The practical result of such situation is again an indirect increase in service costs, as well as lesser promptness in coping with service calls and repair duties.

EP 0 388 728 A2 discloses a part of a frame of an electric appliance, in particular cooking appliance, which forms the control panel of said appliance. Into said control panel various components or programmers of said appliances may be inserted side by side. Said components or programmers have the same heights, so that the abreast places of the components or programmers are interchangeable. The control panel comprises a screen display covering several components or programmers arranged side by side.

EP 1 128 510 A2 discloses a kind of control panel for household appliances, mounting specific arrangements for the electric wiring. The screen display is assembled outside said control panel. There is shown no mounting device, which is able to be connected to different kinds of components or programmers.

It is therefore desirable, and is a main object of the present Invention, actually, to provide a plurality of control panels that are particularly low-cost in both the materials and the production process used, and are further capable of being manufactured so as to fully do away with the above-noted drawbacks, wherein such control panels shall further be capable of being associated to support and interface means that are fully Interchangeable as far as said programmers are concerned, so as to enable a same type of programmer to be mounted and used in appliances of different kind and type, by simply providing and mounting appropriate interface means, or Screen Displays between said programmers and the control panels on which said programmers are to be mounted.

According to the present invention, this aim is reached in a control panel provided with at least an interface mechanical device and at least a plurality of visual graphic means that are mutually interchangeable on said control panel, all of them incorporating the characteristics as set forth and recited in the appended claims.

Features and advantages of the present invention will anyway be more readily understood from the description that is given below by way of nonlimiting example with reference to the accompanying drawings, in which:
Figure 1 is an exploded view of the block composition of a control panel according to the prior art;
Figure 2 is a side section view of the control panel of fig.1, after its assembly;
Figure 3 is a perspective single view of one component alone of a control panel according to the invention;
Figure 4 is a symbolic view of a coupling type between the component of fig. 3 and the respective control panel;
Figure 5 is a side section view of the assembly of fig. 4, when mounted;

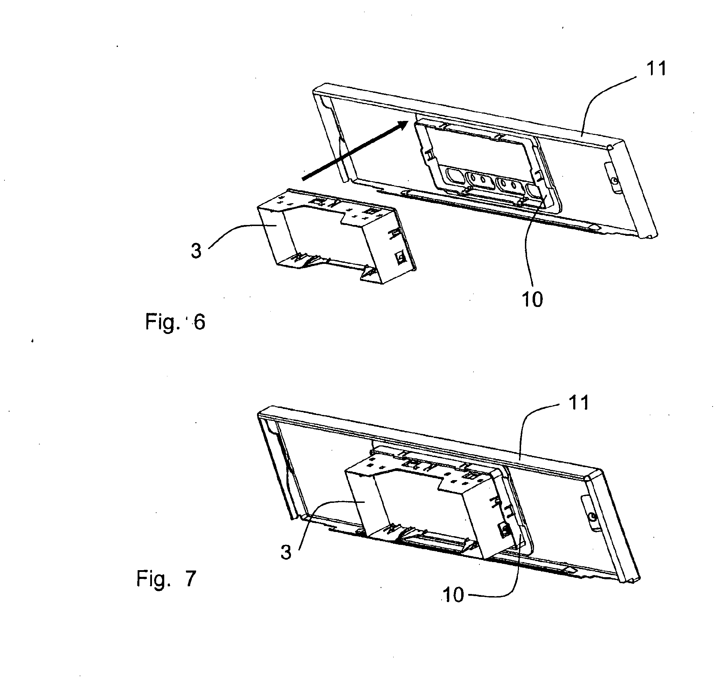

Figure 6 shows an exploded symbolic view of the coupling type between the assembly of fig. 5 and the respective programmer;
Figure 7 shows the elements of fig. 6, when duly assembled;
Figures 8 and 9 show two views of respective main components of the invention, in a position and reciprocal orientation suitable for their reciprocal assembly;
Figures from 10A to 10C show respective views of corresponding assembly steps of the components of figures 8 and 9;
Figure 11 shows a schematic of the assembly criteria of the components of a plurality of control panels according to the prior art;
Figure 12 shows a schematic similar to that one of fig. 11, but referred to a plurality of control panels according to the invention.

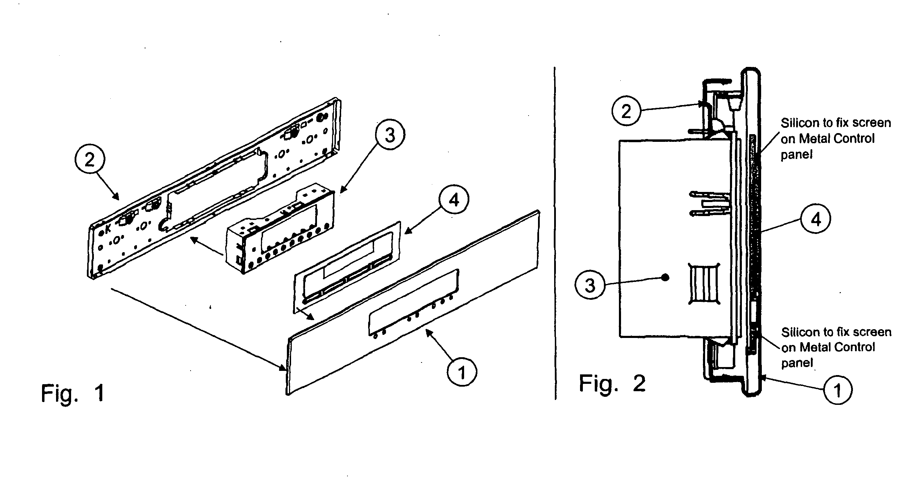

With reference to Figure 1, which illustrates a control panel embodied according to the prior art, there is provided an front panel 1 engaged to an inner support panel 2 behind it; this control panel generally may be completed by a plurality of programmers 3, and by a respective plurality of screen displays 4.

Obviously each control panel mounts only one programmer and only a respective screen display at a time.

However the programmers cannot be mounted alone, but they need a proper graphic mask, i. e. a screen display, able of showing the meaning of the control means to be set/controlled, and also the meaning of the signals the programmer sends out to the user.

As a matter of facts each control panel is identified not only by its own graphic, but also by the information on the appliance operation which are specific for any programmer type; these information are reproduced by a respective graphic mask, or screen display.

Such need is well known, and therefore will not be explained.

With ref. to fig. 2, in order to implement said control panel it is needed to attach, typically using sticking means, the graphic mask, or screen display, to the rear face of the front panel 1, then to connect the programmer to the support panel 2, and finally to mount the support panel, together with its programmer, to the front panel 1.

So it is apparent that any specific type of programmer requires a production of a corresponding type of screen display, suffering the production drawbacks already cited.

With reference to the figures from 3 to 10C, in a control panel according to the invention, said support panel 2 is totally void, so that the electronic programmer 3 requires no autonomous and embodied support panel.

In general, in order to mount a programmer on a control panel, a mounting device 10 is Implemented, that is able to be joined to said front panel, now indicated by the number 11, which is implemented in such a way to lodge not one type only of programmer, but a plurality of different types of programmers.

This is obviously possible if the programmers, which can be selectively joined to a specific control panel, are functionally different, but provided of identical mechanical interfaces.

Therefore a sole and common mounting device 10 is produced, which is firmly joined to a respective front panel 11, so that the assembly formed by said front panel and said mounting device 10 may be Identically used with a plurality of programmers which are different In the functioning features, though mechanically interchangeable.

However, as before explained, due to the need that said programmers have to be associated to a respective screen display, or graphic mask, which is specific for each of the possible control panel to be manufactured, a corresponding plurality of screen displays is implemented, wherein each screen display reproduces the specific graphics for each specific type of control panel.

Each of said screen displays 4 must therefore be designed and realized In such a way to be autonomously and selectively joined on said mounting device 10, and so they are fully interchangeable in the mechanical features, even though, as just explained, they are not identical but different. To summarize, as the man skilled in the art will already understood, each control panel of a particular type, according to the invention will not consist on a unique respective complete but not modular assembly, but will comprise a specific front panel 11 and a common mounting device 10 (here defined in a general way) apt to be mounted on more panels, and that to Its time may mount a plurality of screen displays, which have to be mechanically interchangeable but specialized in their graphics.

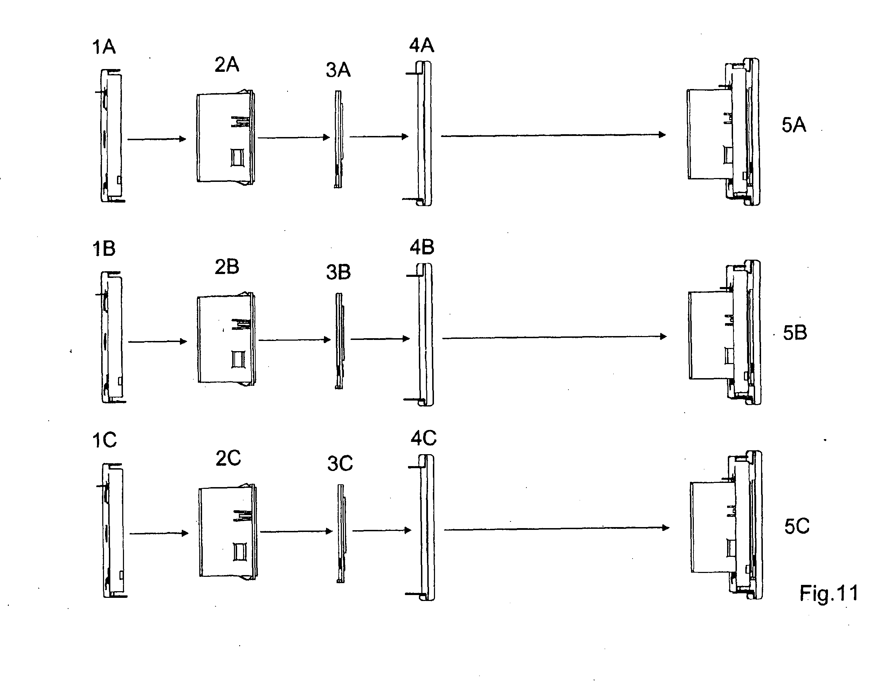

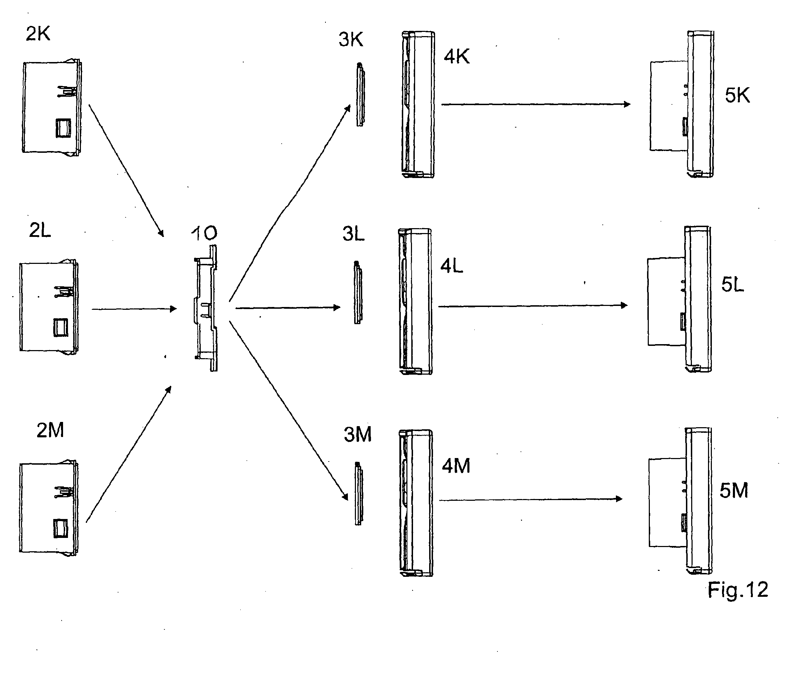

Figures 11 and 12 offer a schematic and logical representation of the invention core; fig. 11 in the facts the schematics according to the prior art, wherein a generic control panel 5A is being obtained a determined support panel 1A with a related programmer 2A, with a related screen display 3A and a related front panel 4A.

The same happens for the others different control panels 5B, 5C, ... etc.

Fig. 12 instead shows the corresponding schematic according to the Invention, wherein a first control panel 5K is being obtained by assembling a determined programmer 2K with a definite mounting device 10 with a related screed display 3K and with a related front panel 4K.

In said case too, a similar situation is given for the others different control panels 5L, 5M, ... and so on.

However it is apparent a main difference: in the second described case the mounting device 10 is the same, that is, it is common to the various types of control panels; therefore it is sufficient to design and realize only one type of such mounting device 10 and not a different type for each model of control panel.

With economic and logistic advantages even too apparent to the man skilled in the art.

But a further and very remarkable advantage is soon apparent: that is in the present invention the single support panels 1A, 1B, 1C etc.. are being simply crossed, as their function Is taken by a specific mounting type among the various front panel 4K, 4L, 4M and the related programmers 2K, 2L, 2M.

Moreover the common mounting device 10 too is being implemented in such a way, and is being mounted on the rear side of the front panels 4K, 4L, 4M with a well known technique, for instance by bl-adhesive strips, but which allows to mount in a simple and interchangeable way the respective screen displays 3K, 3L, 3M.

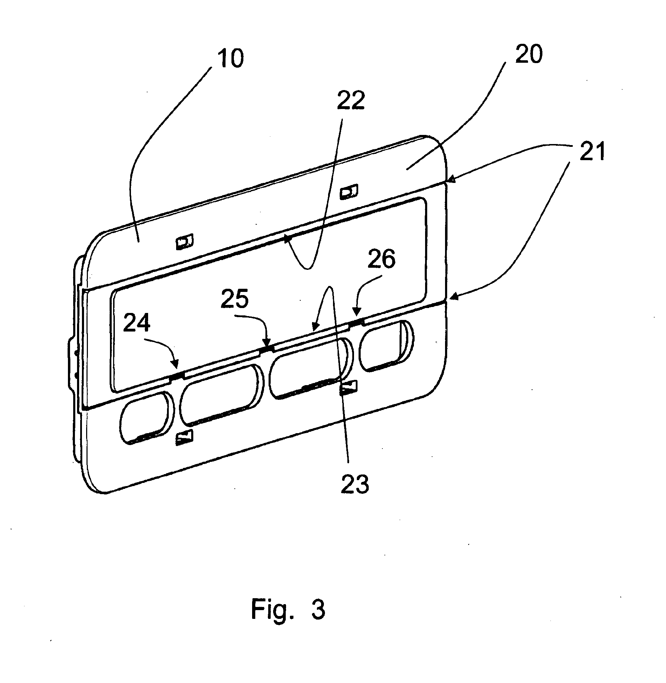

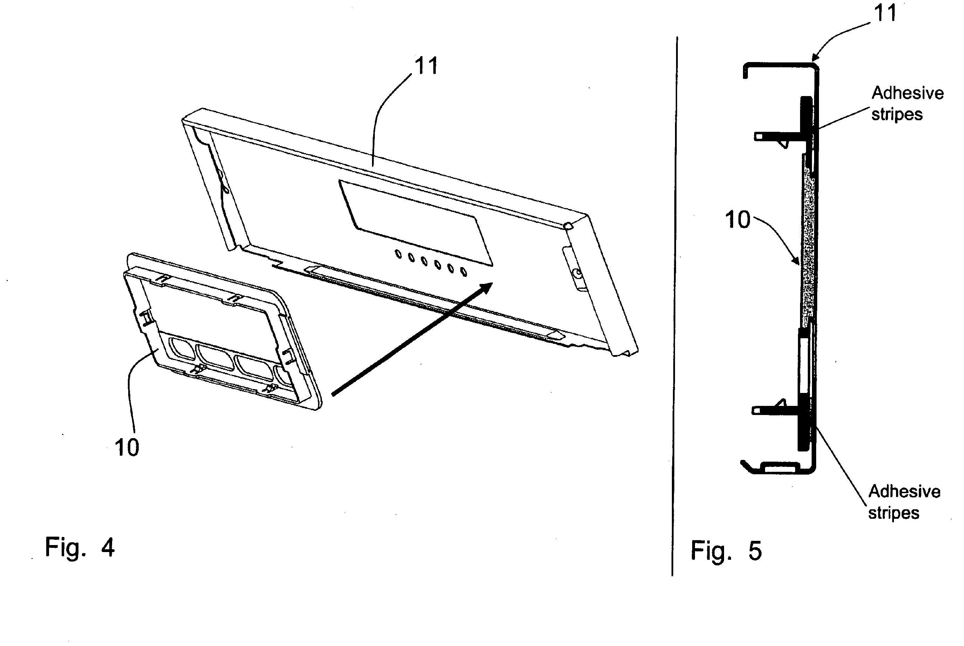

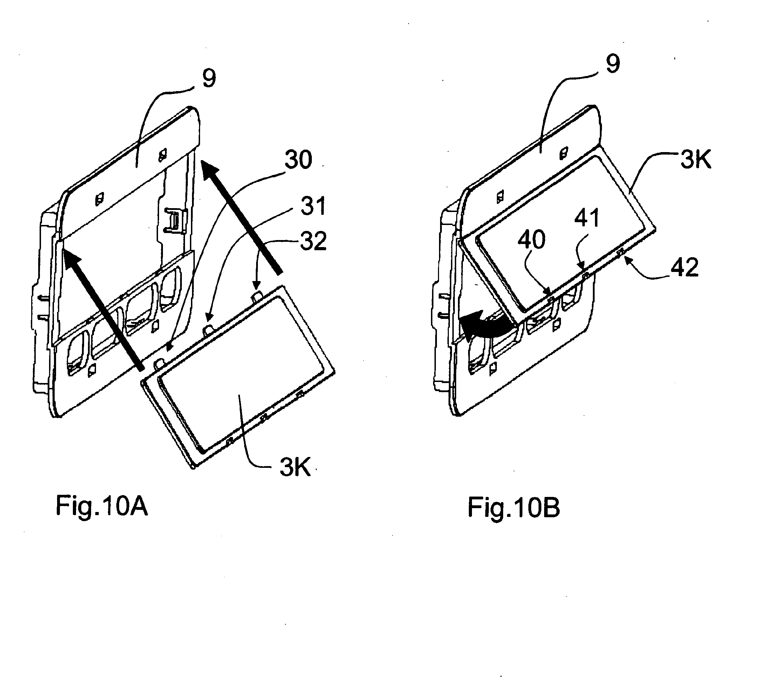

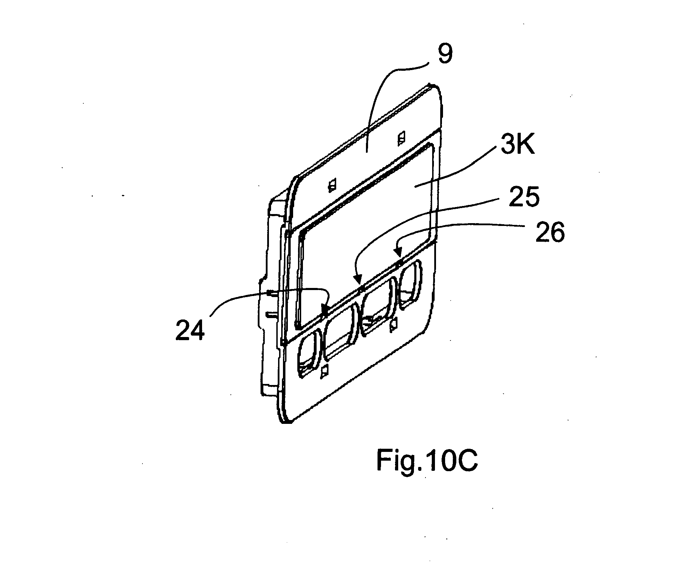

As a matter of facts, with ref. to the figures 3, 5, 8, 9, 10A 10B, 10C, the front portion 20 of said mounting device 10 is so formed with a side shape provided with a linear and horizontal groove 21, extended for mainly the whole device width, and delimited both in the upper and in the lower side by respective edges 22 and 23.

With ref. to fig. 3, on one of said edges, and in the case shown on the lower edge 23, a plurality of stopping protuberances 24, 25, 26 is formed, which are slightly protruding towards the centre of said groove, that is upwards.

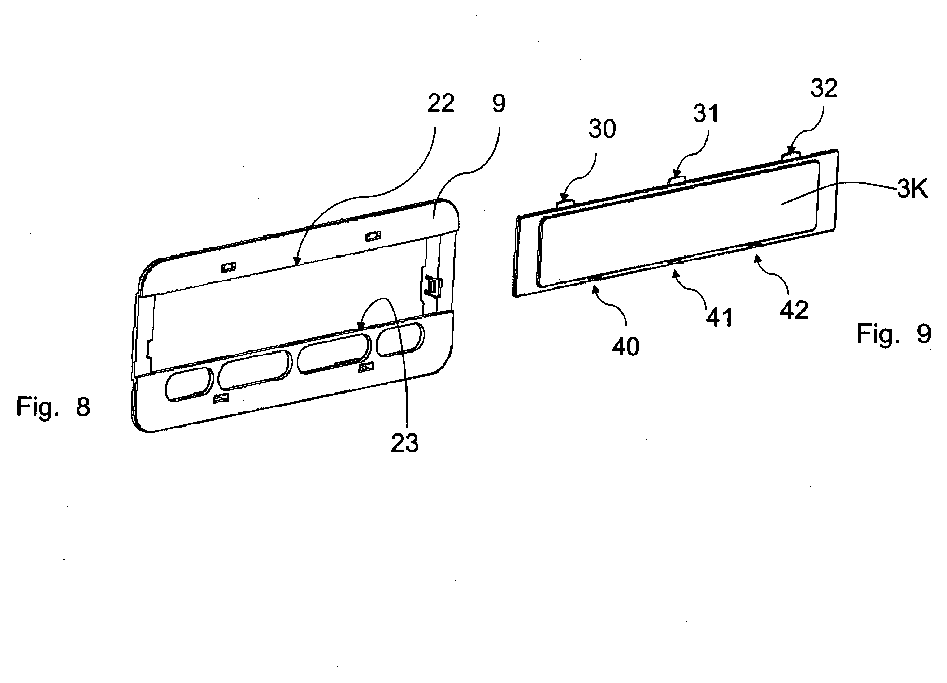

Reciprocally on the upper edge of a related screen display 3K (see fig. 9) a plurality of engaging leaning and grasping bulges 30, 31, 32 is done, which are positioned a little behind and upwards oriented.

On the lower edge of the same screen display some small engaging notches 40, 41, 42 are formed.

The shape, size and reciprocal position of the just described elements must be such that it is possible to mount said screen display on said groove, in a way that:
- said leaning bulges 30, 31 and 32 are being engaged behind the upper edge 22 of said horizontal groove 21, and
- said stopping protuberances 24, 25 and 26 on the lower edge 23 of the groove 21 are introduced into said engaging notches 40, 41 and 42, automatically blocking by a kind of snap stopping, which may be obtained by a light elastic manual forcing between the just described elements 24, 25 and 26 on one side, and 40, 41, and 42 on the opposite side.

In such a way a fully interchangeable mode of associating and joining is implemented, which is simple, immediate and easily removable and without requesting any type of tools, between a common type of mounting device and a respective plurality of screed displays 3K, 3L, 3M and so on.

The just described solution may however be described If the programmers 2K, 2L, 2M are on the back side of the related front panels 4K, 4L, 4M.

As far as the remaining components joined to the control panel are concerned, as switches, thermostats, timers, rotating knobs for the cooking hobs, they may be easily mounted with screws or through-bolts across the same wall of the front panel 11; said screws or bolts protruding at sight on the respective surface are then properly hidden simply implementing some control knobs properly widened, so as to cover said screws or bolts from the user sight; It is also obvious that their position must be properly selected close to the control knobs themselves; however such embodiments, even though very useful for the implementation of the Invention, are known per se, and therefore are not comprised in the invention.

## Claims

1. Control panel comprising:
- a front panel (11, 4K, 4L, 4M),
- a programmer (3, 2K, 2L, 2M) which can be selectively lodged behind said front panel,
- coupling means placed between said front panel and said programmer, wherein said coupling means comprise:
- a mounting device (10) able of supporting said programmer in said front panel, and
- a screen display (3K, 3L, 3M) able of being selectively installed, in a predetermined position, on said mounting device,
**characterized in that**
- the programmer (3, 2K, 2L, 2M) is interchangeable and selectable in a plurality of programmers (3, 2K, 2L, 2M), wherein said programmers (3, 2K, 2L, 2M) are functionally different types of programmers (3, 2K, 2L, 2M) and provided of identical mechanical Interfaces,
- the screen display (3K, 3L, 3M) is interchangeable and selectable in a plurality of screen displays (3K, 3L, 3M), wherein said screen displays (3K, 3L, 3M) are mechanically identical and each screen display (3K, 3L, 3M) reproduces specific graphics for a specific type of control panel, and
- the mounting device (10) is common to the various types of control panels.

2. Control panel according to claim 1, **characterized in that** said screen display (3K, 3L, 3M) are able of being associated In a removable way onto said mounting device, so as to show interchangeability features with respect to it.

3. Control panel according to claim 2, **characterized in that** said mounting device (10) and that screen displays are able of being reciprocally engaged through snap means.

4. Control panel according to claim 3, **characterized In that** said mounting device (10) is provided with a surface horizontal and linear groove (21), and that said screen displays are implemented by suitable flat surfaces able of selectively introducing into said surface groove.

5. Control panel according to claim 4, **characterized in that** said groove (21) and said screen displays are apt of being engaged, through reciprocal joining means (24, 25, 26) ( 40, 41, 42) and leaning means (30, 31, 32) placed on respective connection edges.

6. Control panel according to any one of the preceding claims, **characterized in that** the programmer is an electronic programmer.

## Patentansprüche

1. Bedienfeld, das Folgendes umfasst:
- eine Frontplatte (11, 4K, 4L, 4M)
- einen Programmierer (3, 2K, 2L, 2M), der wahlweise hinter der Frontplatte untergebracht werden kann,
- Kopplungsmittel, die zwischen der Frontplatte und dem Programmierer platziert sind, wobei die Kopplungsmittel umfassen:
- eine Montagevorrichtung (10), die geeignet ist, den Programmierer in der Frontplatte zu stützen, und
- eine Bildschirmanzeige (3K, 3L, 3M), die wahlweise in einer bestimmten Position an der Montagevorrichtung installiert werden kann,
**dadurch gekennzeichnet, dass**
- der Programmierer (3, 2K, 2L, 2M) austauschbar und aus einer Mehrzahl von Programmieren (3, 2K, 2L, 2M) auswählbar ist, wobei die Programmierer (3, 2K, 2L, 2M) funktional unterschiedliche Typen von Programmierern (3, 2K, 2L, 2M) sind und mit identischen mechanischen Schnittstellen ausgestattet sind,
- die Bildschirmanzeige (3K, 3L, 3M) austauschbar und aus einer Mehrzahl von Bildschirmanzeigen (3K, 3L, 3M) auswählbar ist, wobei die Bildschirmanzeigen (3K, 3L, 3M) mechanisch identisch sind und jede Bildschirmanzeige (3K, 3L, 3M) bestimmte Grafiken für einen bestimmten Bedienfeldtyp reproduziert, und
- die Montagevorrichtung (10) den unterschiedlichen Typen von Bedienfeldern gemeinsam ist.

2. Bedienfeld gemäß Anspruch 1, **dadurch gekennzeichnet, dass** die Bildschirmanzeige (3K, 3L, 3M) so ausgeführt ist, dass sie auf abnehmbare Weise mit der Montagevorrichtung verbunden werden kann, um mit Bezug zu dieser Austauschbarkeitseigenschaften aufzuweisen.

3. Bedienfeld gemäß Anspruch 2, **dadurch gekennzeichnet, dass** die Montagevorrichtung (10) und die Bildschirmanzeigen miteinander durch Einschnappmittel verbunden werden können.

4. Bedienfeld gemäß Anspruch 3, **dadurch gekennzeichnet, dass** die Montagevorrichtung (10) mit einer waagrechten und linearen Oberflächenschiene (21) ausgestattet ist und dass die Bildschirmanzeigen anhand geeigneter flacher Oberflächen implementiert werden, die geeignet sind, wahlweise in die Oberflächenschiene eingeführt zu werden.

5. Bedienfeld gemäß Anspruch 4, **dadurch gekennzeichnet, dass** die Schiene (21) und die Bildschirmanzeige mittels wechselseitiger Verbindungsmittel (24, 25, 26) (40, 41, 42) und Neigungsmittel (30, 31, 32) an den entsprechenden Verbindungskanten ineinander eingreifen können.

6. Bedienfeld gemäß einem der vorangehenden Ansprüche, **dadurch gekennzeichnet, dass** der Programmierer ein elektronischer Programmierer ist.

## Revendications

1. Panneau de commande comprenant:
- un panneau avant (11, 4K, 4L, 4M),
- un programmateur (3, 2K, 2L, 2M) qui peut être logé sélectivement derrière ledit panneau avant,
- des moyens de couplage placés entre ledit panneau avant et ledit programmateur, où lesdits moyens de couplage comprennent:
- un dispositif de montage (10) apte à supporter ledit programmateur dans ledit panneau avant, et
- un écran d'affichage (3K, 3L, 3M) apte à être installé sélectivement, dans une position prédéterminée, sur ledit dispositif de montage,
**caractérisé en ce que**
- le programmateur (3, 2K, 2L, 2M) est interchangeable et peut être sélectionné parmi une pluralité de programmateurs (3, 2K, 2L, 2M), où lesdits programmateurs (3, 2K, 2L, 2M) sont des types fonctionnellement différents de programmateurs (3, 2K, 2L, 2M) et réalisés par des interfaces mécaniques identiques,
- l'écran d'affichage (3K, 3L, 3M) est interchangeable et peut être sélectionné parmi une pluralité d'écrans d'affichage (3K, 3L, 3M), où lesdits écrans d'affichage (3K, 3L, 3M) sont mécaniquement identiques, et chaque écran d'affichage (3K, 3L, 3M) reproduit des graphiques spécifiques pour un type spécifique de panneau de commande, et
- le dispositif de montage (10) est commun aux divers types de panneau de commande.

2. Panneau de commande selon la revendication 1, **caractérisé en ce que** lesdits écrans d'affichage (3K, 3L, 3M) sont aptes à être associés d'une manière amovible audit dispositif de montage de manière à montrer les caractéristiques d'interchangeabilité relativement à celui-ci.

3. Panneau de commande selon la revendication 2, **caractérisé en ce que** ledit dispositif de montage (10) et les écrans d'affichage sont aptes à être mis en prise réciproquement par des moyens d'encliquetage.

4. Panneau de commande selon la revendication 3, **caractérisé en ce que** ledit dispositif de montage (10) présente une rainure de surface horizontale et linéaire (21), et que lesdits écrans d'affichage sont réalisés par des surfaces plates appropriées aptes à être introduites sélectivement dans ladite rainure de surface.

5. Panneau de commande selon la revendication 4, **caractérisé en ce que** ladite rainure (21) et lesdits écrans d'affichage sont aptes à être mis en prise, par des moyens de jonction réciproques (24, 25, 26) (40, 41, 42) et des moyens d'appui (30, 31, 32) placés sur des bords de connection respectifs.

6. Panneau de commande selon l'une quelconque des revendications précédentes, **caractérisé en ce que** le programmateur est un programmateur électronique.
